# FASCICULE DE BREVET EUROPEEN

(11) **EP 1 755 222 B1**
(45) Date de publication et mention de la délivrance du brevet: **07.10.2009**
(21) Numéro de dépôt: 06118095.6
(22) Date de dépôt: 28.07.2006
(51) Int. Cl.: H03K 19/003

(54) **Cellule logique à deux sorties redondantes isolées, et circuit intégré correspondant**
Logikzelle mit zwei isolierten redundanten Ausgängen, und integrierte Schaltung dafür
Logic cell having two isolated redundant outputs, and correspondant integrated circuit

(30) Priorité: 18.08.2005 FR 0508606
(43) Date de publication de la demande: 21.02.2007
(73) Titulaire: ATMEL NANTES SA, 44306 Nantes Cédex 3 (FR)
(72) Inventeur: Briet, Michel, 44850 Ligne (FR); Verdant, Arnaud, 44400 Reze (FR)
(74) Mandataire: Guéné, Patrick

(56) Documents cités:
- US-A- 5 111 429
- US-A- 5 406 513
- US-A- 5 418 473
- US-A- 6 133 747
- US-A1- 2005 168 250

## Description

### 1. Domaine de l'invention

Le domaine de l'invention est celui des circuits électroniques intégrés, notamment de type CMOS, et plus particulièrement des circuits comprenant des cellules logiques, tels que les portes logiques, les mémoires ou encore les microprocesseurs.

Plus précisément, l'invention concerne le durcissement de cellule logique dans de tels circuits. Par durcissement, on entend la désensibilisation d'un circuit intégré vis-à-vis des particules ionisantes présentes dans un environnement radiatif.

### 2. Solutions et inconvénients de l'art antérieur

De façon générale, les particules rencontrées dans les différents environnements radiatifs (par exemple l'environnement radiatif spatial ou atmosphérique) interagissent avec les matériaux composant un circuit intégré, notamment les matériaux semi-conducteurs (par exemple le silicium).

Les effets de l'impact d'une particule chargée sur un circuit intégré peuvent être divisés en deux catégories : les effets cumulatifs (ou effets de dose) pouvant modifier les caractéristiques électriques du composant (tension de seuil, gain des transistors...) et les effets singuliers (ou SEE, pour « Single Event Effects » en anglais).

On discute ci-après les inconvénients de l'art antérieur à travers le cas particulier des effets singuliers de type SET (pour « Single Event Transient » en anglais) sur une porte logique NON-ET.

On rappelle qu'un SET, aussi appelé impulsion transitoire de tension ou aléa transitoire, est initié lorsqu'une particule ionisante heurte la jonction bloquée d'un transistor MOSFET. Généralement, le passage d'une particule ionisante (par exemple un ion lourd) à travers la jonction polarisée en inverse d'un transistor, se traduit par la création de paires électron-trou dans une zone axée sur la trace de la particule incidente. Ces paires électron-trou peuvent modifier la répartition du champ électrique dans le substrat, provoquant ainsi une collection par dérive des électrons et des trous. Ce mécanisme de collection par dérive, aussi appelé par la suite « funneling », peut être à l'origine de l'apparition d'une impulsion transitoire de tension (SET).

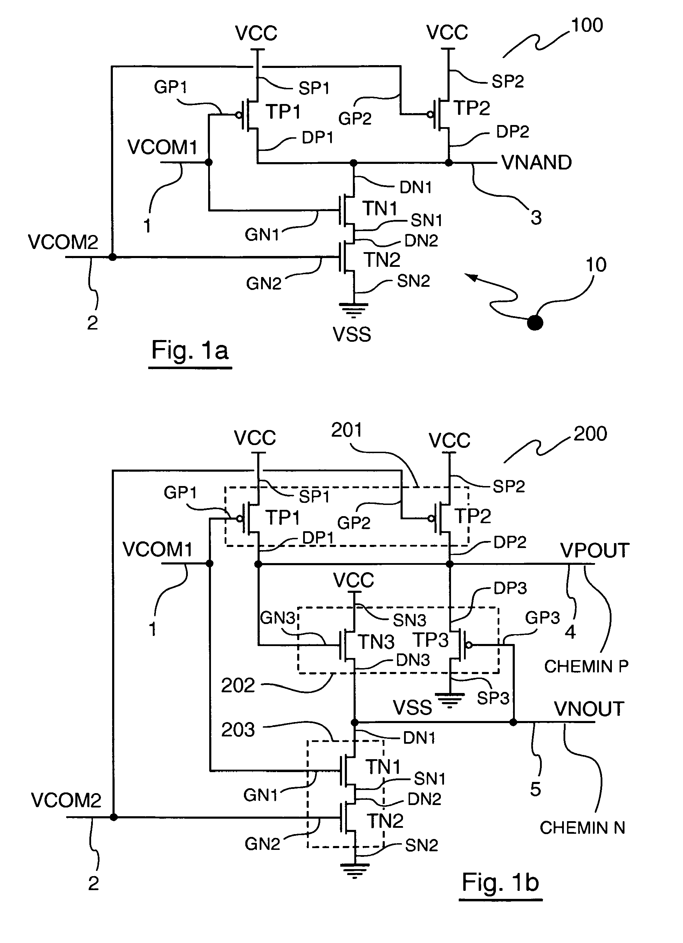

On décrit en référence à la **figure 1a****,** les mécanismes d'impact (d'un ion lourd) pour le cas d'une porte logique NON-ET.

Par souci de simplification de la description, on se limitera, dans toute la suite de ce document, à décrire le cas particulier des circuits intégrés fonctionnant sous des tensions de référence de 0V et 3V. L'Homme du Métier étendra sans difficulté cet enseignement à tout type de tension destinée à alimenter un circuit électronique intégré.

La porte logique NON-ET 100 reçoit sur une première entrée 1 une première tension de commande VCOM1 et sur une deuxième entrée 2 une seconde tension de commande VCOM2 et délivre en sortie 3 une tension résultante VNAND.

Cette porte logique NON-ET 100 comprend elle-même un transistor TN1, dont la grille GN1 forme la première entrée 1 (sur laquelle est appliquée directement la première tension de commande VCOM1) et dont le drain DN1 est relié à la sortie 3, et un transistor TN2, dont la grille GN2 forme la deuxième entrée 2 (sur laquelle est appliquée la seconde tension de commande VCOM2). La source SN2 du transistor TN2 est reliée au potentiel de référence VSS (aussi appelé niveau bas dans la suite de la description), par exemple de 0V, et le drain DN2 du transistor TN2 est relié à la source SN1 du transistor TN1.

La porte logique NON-ET 100 comprend en outre deux transistors TP1 et TP2, dont les grilles GP1 et GP2 reçoivent respectivement la première tension de commande VCOM1 et la seconde tension de commande VCOM2. Les sources SP1 et SP2 des transistors TP1 et TP2 sont reliées à l'alimentation VCC du circuit (aussi appelée niveau haut dans la suite de la description), par exemple de 3V, et leurs drains DP1 et DP2 sont reliés au drain DN1 du transistor TN1.

Ainsi, lorsque les première et seconde tensions de commande VCOM1 et VCOM2 sont sensiblement égales à l'alimentation VCC, soit 3V, alors la tension résultante VNAND, délivrée en sortie 3, est sensiblement égale au potentiel de référence VSS, soit 0V.

A l'inverse, lorsque la première tension de commande VCOM1 ou(et) la seconde tension de commande VCOM2 est(sont) sensiblement égale(s) au potentiel de référence VSS, soit 0V, alors la tension résultante VNAND, délivrée en sortie 3, est sensiblement égale à l'alimentation VCC, soit 3V.

Comme déjà indiqué, un ion lourd peut donner naissance à un aléa transitoire en sortie 3 de la porte logique NON-ET 100.

En effet, dans un premier cas d'impact, dans lequel les transistors TP1 et TP2 sont tous deux dans un état bloqué (c'est-à-dire lorsque les tensions de commande VCOM1 et VCOM2 sont égales à 3V), si un ion lourd 10 touche le transistor TP1, alors une impulsion transitoire de tension apparaît en sortie 3. Cette impulsion, aussi appelée « pulse » de bas vers haut, correspond aux commutations successives de la tension résultante VNAND de 0V (niveau bas) à 3V (niveau haut), puis de 3V à 0V.

Dans un second cas d'impact, dans lequel les transistors TP1 et TP2 sont tous deux dans un état bloqué (c'est-à-dire lorsque les tensions de commande VCOM1 et VCOM2 sont égales à 3V), si un ion lourd 10 touche le transistor TP2, alors un pulse de bas vers haut apparaît en sortie 3.

Ensuite, dans un troisième cas d'impact, dans lequel le transistor TN1 est dans un état bloqué (c'est-à-dire lorsque la tension de commande VCOM1 est égale à 0V) et le transistor TN2 est dans un état passant (c'est-à-dire lorsque la tension de commande VCOM2 est égale à 3V), si un ion lourd 10 touche le transistor TN1, alors une impulsion transitoire de tension apparaît en sortie 3. Cette impulsion, aussi appelée pulse de haut vers bas, correspond aux commutations successives de la tension résultante VNAND de 3V (niveau haut) à 0V (niveau bas), puis de 0V à 3V.

Enfin, dans un quatrième cas d'impact, dans lequel le transistor TN2 est dans un état bloqué (c'est-à-dire lorsque la tension de commande VCOM2 est égale à 0V) et le transistor TN1 est dans un état passant (c'est-à-dire lorsque la tension de commande VCOM1 est égale à 3V), si un ion lourd 10 touche le transistor TN2, alors un pulse de haut vers bas apparaît en sortie 3.

Ces impulsions transitoires de tension générées en sortie 3 de la porte NON-ET 100 peuvent provoquer une erreur logique, conduisant à une défaillance critique du système dans lequel la porte logique 100 est implémentée.

Une technique bien connue permettant d'empêcher la propagation d'une information erronée (c'est-à-dire un SET) dans un ensemble de cellules logiques montées en cascade, repose sur l'utilisation de transistors intermédiaires.

Cette technique de durcissement consiste à fournir deux sorties redondantes (par exemple, la demande de brevet américain n°US 2005/0168250 décrit un circuit intégré comprenant deux sorties redondantes) et à placer un ensemble de transistors intermédiaires PMOS et NMOS entre un premier bloc de transistors, comprenant uniquement des transistors PMOS, et un deuxième bloc de transistors, comprenant uniquement des transistors NMOS, de façon à individualiser le premier bloc du deuxième bloc.

En d'autres termes, cet ensemble de transistors intermédiaires permet de ne pas propager un SET apparaissant sur la sortie du premier bloc vers la sortie du deuxième bloc, et inversement.

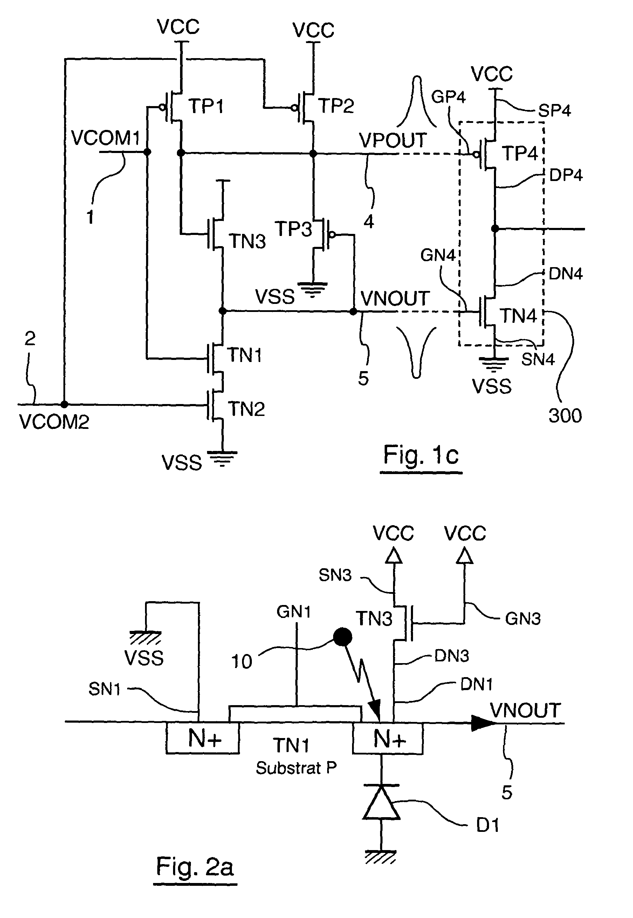

On va décrire maintenant en relation avec la **figure 1b****,** une cellule de ce type, connue sous le terme anglais « Dual Stream Redundancy » (ou « redondance par double flux de données », en français), référencée 200. Par exemple, le brevet américain n°US-A-6 133 747 décrit (notamment en relation avec sa figure 1) une cellule de ce type.

Comme on le verra, sur toutes les figures du présent document, les éléments identiques sont désignés par une même référence numérique.

La cellule « Dual Stream » 200, comprend une paire de transistors intermédiaires 202 placée entre un premier bloc de transistors PMOS 201 et un deuxième bloc de transistors NMOS 203.

Le premier bloc de transistors PMOS 201 comprend les transistors TP1 et TP2 de la porte logique NON-ET 100 (figure la). Les sources SP1 et SP2 des transistors TP1 et TP2 sont reliées à l'alimentation VCC du circuit et leurs drains DP1 et DP2 sont reliés entre eux, de façon à former une première sortie 4, aussi appelée chemin P dans la suite de la description.

Le deuxième bloc de transistors NMOS 203 comprend les transistors TN1 et TN2 de la porte logique NON-ET 100 (figure la). La source SN2 du transistor TN2 est reliée au potentiel de référence VSS et son drain DN2 est relié à la source SN1 du transistor TN1, dont le drain DN1 forme une deuxième sortie 5, aussi appelée chemin N dans la suite de la description.

La paire de transistors intermédiaires 202 comprend un premier transistor intermédiaire TN3, dont la grille GN3 est reliée à la première sortie 4 et le drain DN3 est relié à la deuxième sortie 5. La source SN3 du transistor TN3 est reliée à l'alimentation VCC.

La paire de transistors intermédiaires 202 comprend en outre un second transistor intermédiaire TP3, dont la grille GP3 est reliée à la deuxième sortie 5 (chemin N) et le drain DP3 est relié à la première sortie 4 (chemin P). La source SP3 du transistor TP3 est reliée au potentiel de référence VSS.

Par souci de clarté, on ne décrit ci-après que le fonctionnement de la cellule Dual Stream pour différentes valeurs de la première tension de commande VCOM1 et pour une seconde tension de commande VCOM2 égale à l'alimentation VCC.

Lorsque la seconde tension de commande VCOM2 est égale à 3V, le transistor TP2 est placé dans un état bloqué (interrupteur ouvert) et le transistor TN2 dans un état passant (interrupteur fermé), dans lequel il relie la source SN1 du transistor TN1 au potentiel de référence VSS.

La **figure 2a** présente le schéma simplifié de la cellule Dual Stream 200 pour le cas où la première tension de commande VCOM1 est égale au potentiel de référence VSS. Lorsque la première tension de commande VCOM1 est égale à 0V, le transistor TN1 est placé dans un état bloqué et le transistor TP1 dans un état passant, dans lequel il polarise la grille GN3 du transistor intermédiaire TN3 avec un niveau haut, soit 3V. Le transistor intermédiaire TN3 est donc dans un état passant, dans lequel il fixe la tension de sortie VNOUT, délivrée sur le chemin N, à un niveau haut dégradé (c'est-à-dire à un niveau égal à la différence entre le niveau haut de 3V et la tension de seuil du transistor (généralement de 0,7V)). La diode (de la jonction) PN verticale D1 du transistor d'entrée TN1 est polarisée en inverse. Lors du passage d'une particule ionisante 10 (ou ion lourd), le phénomène de funneling court-circuite la diode D1 et entraîne le passage transitoire de la tension de sortie VNOUT de 3V (niveau haut) à 0V (niveau bas). Grâce à la présence du transistor intermédiaire TN3, placé entre le chemin P et le chemin N, le pulse (SET) de haut vers bas généré sur le chemin N n'est pas propagé vers le chemin P. La tension de sortie VPOUT, délivrée sur le chemin P, reste intacte, c'est-à-dire égale à l'alimentation VCC de 3V (du fait que le transistor TP1 est passant).

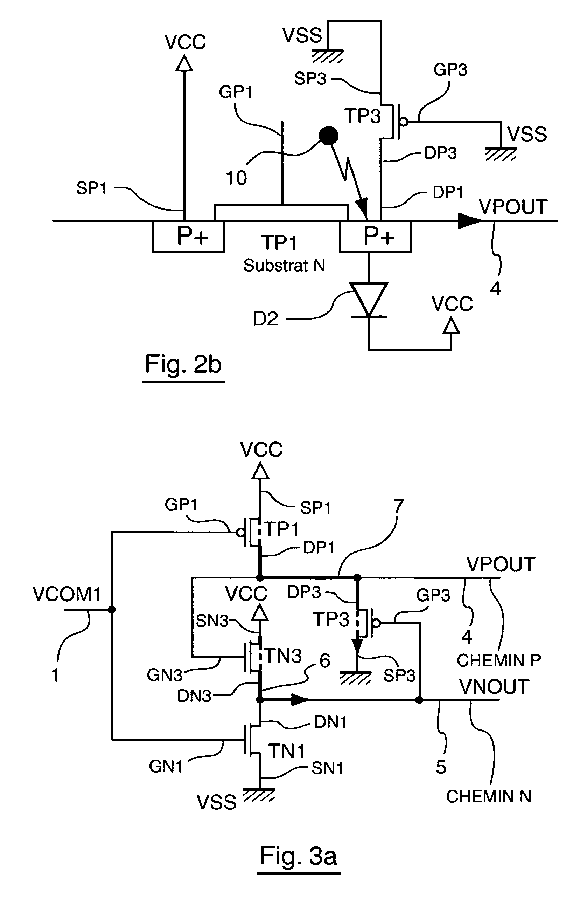

La **figure 2b** présente le schéma simplifié de la cellule Dual Stream 200 pour le cas où la première tension de commande VCOM1 est égale à l'alimentation VCC. Lorsque la première tension de commande VCOM1 est égale à 3V, le transistor TP1 est placé dans un état bloqué et le transistor TN1 dans un état passant, dans lequel il polarise la grille GP3 du transistor intermédiaire TP3 avec un niveau bas, soit 0V. Le transistor intermédiaire TP3 est donc dans un état passant, dans lequel il fixe la tension de sortie VPOUT, délivrée sur le chemin P, à un niveau bas dégradé (c'est-à-dire à un niveau égal à la tension de seuil du transistor, soit 0,7V). La diode (de la jonction) PN verticale D2 du transistor d'entrée TP1 est polarisée en inverse. Lors du passage d'une particule ionisante 10 (ou ion lourd), le phénomène de funneling court-circuite la diode D2 et entraîne le passage transitoire de la tension de sortie VPOUT de 0V (niveau bas) à 3V (niveau haut). Grâce à la présence du transistor intermédiaire TP3, placé entre le chemin P et le chemin N, le pulse (SET) de bas vers haut généré sur le chemin P n'est pas propagé vers le chemin N. La tension de sortie VNOUT, délivrée sur le chemin N, reste intacte, c'est-à-dire égale au potentiel de référence VSS de 0V (du fait que le transistor TN1 est passant).

Lorsque les transistors intermédiaires TN3 et TP3 se trouvent impactés par une particule ionisante au moment où ils sont bloqués (TN3 est bloqué quand VCOM1 est au niveau haut et TP3 est bloqué quand VCOM1 est au niveau bas), l'absence de tension aux bornes des diodes PN verticales D1 et D2 des transistors TN1 et TP1 empêche le phénomène de funneling et les impulsion transitoires générées sur les chemins N et P sont alors très faibles. Dans ce cas, l'évacuation des charges se fait par recombinaison.

Ainsi, cette cellule Dual Stream permet de maintenir les pulses de haut vers bas sur le chemin N et les pulses de bas vers haut sur le chemin P. En d'autres termes, lors d'un impact d'une particule ionisante, la cellule Dual Stream autorise soit le basculement de la tension de sortie VNOUT vers le niveau bas soit le basculement de la tension de sortie VPOUT vers le niveau haut.

La cellule Dual Stream est donc insensible aux SET du fait qu'elle permet de délivrer sur au moins un chemin P ou N une information non erronée.

Comme illustré par la **figure 1c****,** la cellule Dual Stream 200 peut être connectée à un inverseur 300 comprenant lui-même deux transistors TP4 et TN4, dont les grille GP4 et GN4 reçoivent respectivement les tensions de sortie VPOUT et VNOUT, de sorte que :
- lorsque la tension VPOUT est au niveau bas le transistor TP4 est placé dans un état passant, dans lequel il fixe la tension de sortie (non représentée) au niveau haut, soit 3V ;
- lorsque la tension VNOUT est au niveau haut le transistor TN4 est placé dans un état passant, dans lequel il fixe la tension de sortie (non représentée) au niveau bas, soit 0V.

Ainsi, lorsque les tensions de sortie VPOUT et VNOUT présentent de courtes perturbations (SET), il est possible d'avoir une configuration de sortie à haute impédance dans laquelle l'inverseur mémorise l'état courant de la tension de sortie (pas de modification de la tension de sortie).

Cette cellule Dual Stream a représenté un progrès important dans les mécanismes de durcissement des circuits intégrés. Cependant, elle présente un certain nombre d'inconvénients.

Tout d'abord, cette solution de l'art antérieur présente une consommation électrique en statique trop élevée. En effet, les transistors intermédiaires TP3 et TN3 transmettent respectivement un niveau bas dégradé sur le chemin P et un niveau haut dégradé sur le chemin N.

En référence à la **figure 3a**, lorsque la première tension de commande VCOM1 est égale au niveau bas, le transistor TP1 vient polariser la grille GN3 du transistor intermédiaire TN3. Ce dernier dont la source SN3 est reliée à l'alimentation VCC du circuit, transmet sur son drain DN3 un niveau haut légèrement dégradé 6, entraînant une très légère saturation du transistor intermédiaire TP3. Cette très légère saturation va donc créer un chemin direct 7 entre l'alimentation et le potentiel de référence, provoquant ainsi une hausse de la consommation en courant.

Par niveau dégradé, on entend un niveau décalé par la tension de seuil du transistor.

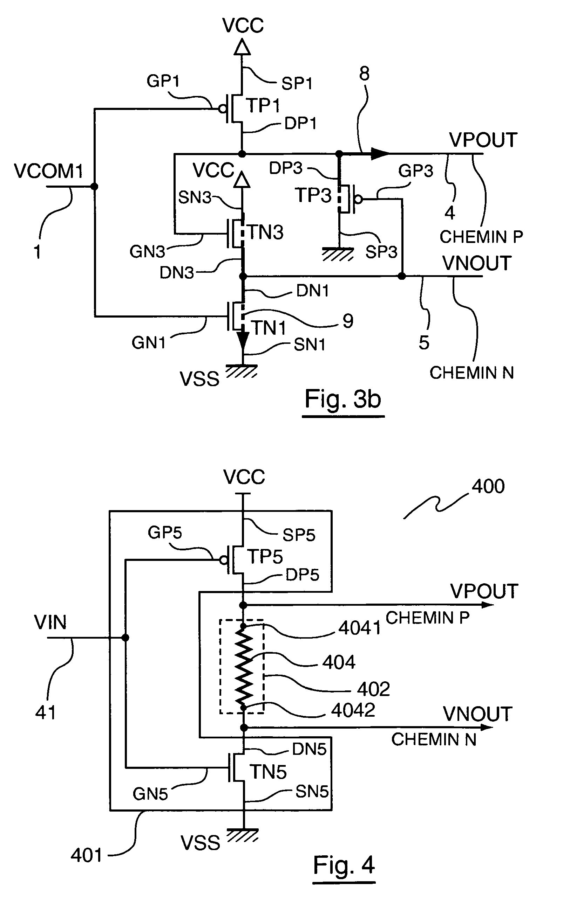

Réciproquement, et comme illustré par la **figure 3b**, lorsque la première tension de commande VCOM1 est égale au niveau haut, le transistor TN1 vient polariser la grille GP3 du transistor intermédiaire TP3. Ce dernier dont la source SP3 est reliée au potentiel de référence VSS du circuit, transmet sur son drain DP3 un niveau bas légèrement dégradé 8, entraînant une très légère saturation du transistor intermédiaire TN3. Cette très légère saturation va donc créer un chemin direct 9 entre l'alimentation et le potentiel de référence, provoquant ainsi une hausse de la consommation en courant.

Comme déjà indiqué (figure 1c), la cellule Dual Stream doit être montée en série avec un inverseur, de façon à pouvoir reconstituer un signal de sortie non perturbé.

Un autre inconvénient majeur de cette technique connue réside donc dans le fait que l'inverseur est sensible à l'impact des particules ionisantes.

### 3. Objectifs de l'invention

L'invention a notamment pour objectif de pallier ces inconvénients de l'art antérieur.

Plus précisément, un objectif de l'invention est de fournir une technique de durcissement qui soit simple à mettre en oeuvre et efficace, notamment en terme de consommation électrique.

Un autre objectif de l'invention est de proposer une telle technique qui, dans un mode de réalisation particulier, permette de minimiser un décalage temporel entre les signaux des chemins P et N de la cellule logique.

Un autre objectif de l'invention est de proposer une telle technique qui permette de réduire fortement l'amplitude et la largeur des SET sur les chemins P et N de la cellule logique.

L'invention a encore pour objectif de fournir une telle technique qui ne conduise pas à une augmentation notable de la taille du circuit intégré.

L'invention a également pour objectif de fournir une telle technique qui, dans au moins un mode de réalisation, soit peu coûteuse et adaptée à toutes les tensions d'alimentation standards des circuits intégrés actuels.

Un dernier objectif de l'invention est de fournir une telle technique qui, dans un mode de réalisation particulier, soit notamment bien adaptée à la mise en cascade de cellules logiques CMOS.

### 4. Exposé de l'invention

Ces objectifs, ainsi que d'autres qui apparaîtront par la suite, sont atteints à l'aide d'une cellule logique pour circuit intégré, comprenant deux sorties redondantes, une première sortie équipée d'un transistor de sortie de type P et une seconde sortie équipée d'un transistor de sortie de type N.

Selon l'invention, la cellule logique comprend un circuit d'isolation reliant lesdites première et seconde sorties et formant résistance d'isolation.

Ainsi, l'invention repose sur une approche tout à fait nouvelle et inventive du durcissement d'une cellule logique CMOS. En effet, l'invention propose d'intercaler une résistance entre les deux sorties de la cellule. Cette résistance permet ainsi d'empêcher la propagation d'impulsions transitoires (ou SET) d'une sortie à une autre. En outre, la consommation électrique statique de la cellule est fortement réduite, du fait que toute liaison directe entre l'alimentation du circuit et la masse est supprimée.

Selon un aspect avantageux de l'invention, ladite résistance d'isolation est inférieure à la résistance du premier et/ou du second transistors de sortie.

Selon l'invention, la résistance d'isolation et les résistances des transistors de sortie forment un pont diviseur en tension, permettant de réduire l'amplitude et la largeur des impulsions transitoires d'une sortie à une autre.

De façon préférentielle, ledit circuit d'isolation comprend un premier transistor d'isolation de type P monté en série avec un second transistor d'isolation de type N, les drains des premier et second transistors d'isolation étant connectés respectivement aux drains des premier et second transistors de sortie.

De façon avantageuse, la grille du premier transistor d'isolation est reliée à une première tension de référence et la grille du second transistor d'isolation est reliée à une seconde tension de référence.

Ainsi, l'invention propose un contrôle indépendant des transistors d'isolation.

Préférentiellement, la première tension de référence est une masse et la seconde tension de référence est une tension d'alimentation.

Selon l'invention, chaque transistor d'isolation est configuré dans un état passant, dans lequel il joue le rôle d'une résistance.

Avantageusement, la largeur du canal de chacun desdits transistors d'isolation est inférieure à la moitié de la largeur du canal de chacun desdits transistors de sortie.

Dans un mode de réalisation préférentiel de l'invention, ledit circuit d'isolation comprend des moyens de synchronisation entre les signaux présents sur lesdites première et seconde sorties.

L'invention propose donc une compensation des retards, dus à l'insertion d'un chemin résistif entre les sorties.

Avantageusement, les moyens de synchronisation comprennent un premier transistor de dérivation de type P, dont la grille est reliée à la grille du transistor de sortie de type P, la source est reliée à la seconde tension de référence et le drain est relié aux sources des transistors d'isolation, et un second transistor de dérivation de type N dont la grille est reliée à la grille du transistor de sortie de type N, la source est reliée à la première tension de référence et le drain est relié aux sources des transistors d'isolation.

Selon un aspect avantageux de l'invention, la cellule logique comprend en outre des moyens de filtrage d'au moins une perturbation des signaux présents sur la première et/ou la seconde sortie due à au moins une particule chargée sur au moins un des transistors.

Ainsi, il est possible de diminuer l'amplitude et la largeur des impulsions transitoires apparaissant sur la sortie reliée au transistor impacté par la particule ionisante.

De façon préférentielle, lesdits moyens de filtrage comprennent au moins un transistor à caisson commandé.

De façon avantageuse, lesdits moyens de filtrage comprennent un premier transistor de filtrage de type P à caisson commandé dont la source est reliée à la seconde sortie, le drain à la première sortie et la grille à l'entrée de ladite cellule et/ou un second transistor de filtrage de type N à caisson commandé dont le drain est relié à la seconde sortie, la source à la première sortie et la grille à l'entrée de ladite cellule.

Selon l'invention, le ou les transistors à caisson commandé jouent le rôle de diode, permettant d'évacuer les charges de l'impulsion transitoire dans le substrat du transistor à caisson commandé. Ainsi, il est possible d'obtenir un filtrage ou une réduction des pics dus aux impacts d'ions lourds. De plus, le ou les transistors à caisson commandé permettent d'obtenir une cellule qui fonctionne à plus haute vitesse en dynamique. En effet, ils permettent de compenser l'effet de réduction de la dynamique de la résistance d'isolation. Par ailleurs, ils permettent en outre de transmettre le signal d'une sortie donnée sur une autre sortie, sans dégradation de ce signal.

Dans un mode de réalisation préférentiel de l'invention, ledit circuit d'isolation comprend un troisième transistor d'isolation de type P à caisson commandé dont la source est reliée à la seconde sortie, le drain à la première sortie et la grille à l'entrée de ladite cellule et un quatrième transistor d'isolation de type N à caisson commandé dont le drain est relié à la seconde sortie, la source à la première sortie et la grille à l'entrée de ladite cellule.

Ainsi, l'invention propose un circuit d'isolation capable de filtrer ou réduire l'amplitude et la largeur des impulsions transitoires.

Préférentiellement, la source du transistor de sortie de type P est reliée à la seconde tension de référence et la source du transistor de sortie de type N est reliée à la première tension de référence et l'entrée de ladite cellule est reliée aux grilles des transistors de sortie.

Ainsi, les transistors de sortie forment un inverseur.

L'invention concerne également un circuit intégré comprenant une cellule logique telle que décrite ci-dessus.

### 5. Liste des figures

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :
- les figures 1a à 1c, déjà commentées en relation avec l'art antérieur, présentent :

- figure 1a : le schéma d'une porte logique NON-ET classique à base de transistors CMOS ;
- figure 1b : le schéma d'une cellule Dual Stream classique à base de transistors intermédiaires ; et
- figure 1c : le schéma d'un inverseur monté en cascade avec la cellule de la figure 1b ;
- les figures 2a et 2b illustrent, respectivement, des premier et deuxième cas d'impact d'une particule ionisante sur la cellule de la figure 1b ;
- les figures 3a et 3b illustrent, respectivement, le fonctionnement de la cellule Dual Stream classique pour les premier et deuxième cas des figures 2a et 2b ;
- la figure 4 présente le schéma d'une cellule logique CMOS selon un mode de réalisation préférentiel de l'invention ;
- les figures 5a et 5b illustrent le fonctionnement de la cellule logique CMOS de la figure 4 ;
- la figure 6 présente le schéma détaillé d'une résistance d'isolation selon un premier mode de réalisation préférentiel de l'invention ;
- la figure 7 présente le schéma détaillé d'une résistance d'isolation selon un second mode de réalisation préférentiel de l'invention ;
- les figures 8a et 8b illustrent, respectivement, le schéma détaillé et le fonctionnement d'une résistance d'isolation selon un troisième mode de réalisation préférentiel de l'invention ; et
- la figure 9 présente le schéma détaillé d'une résistance d'isolation selon un quatrième mode de réalisation préférentiel de l'invention.

### 6. Description détaillée de l'invention

Le principe général de l'invention repose sur l'insertion d'un mécanisme de découplage résistif entre les sorties d'une cellule logique.

Selon l'invention, un circuit d'isolation comprennent des transistors PMOS et NMOS, permettant de créer un chemin résistif entre les sorties de la cellule logique.Ce circuit d'isolation permetd'isoler les impulsions transitoires (ou SET) d'une sortie à une autre, et le cas échéant de les supprimer soit par évacuation des charges soit par restitution de niveau.

Par souci de simplification de la description, on se limitera, dans toute la suite de ce document, à décrire une cellule logique de type inverseur à deux sorties, dans laquelle est implanté un mécanisme de découplage résistif. L'Homme du Métier étendra sans difficulté cet enseignement à tout type de cellule logique équipée de deux sorties, par exemple une porte logique NON-ET, un point mémoire SRAM (pour « Static Random Access Memory » en anglais),....

On décrit désormais en relation avec la **figure 4** une cellule logique CMOS 400 selon un mode de réalisation préférentiel de l'invention.

Dans ce mode de réalisation, la cellule logique CMOS 400 selon l'invention comprend :
- un circuit d'isolation 402 incluant une résistance d'isolation 404 spécifiques à l'invention ; et
- un inverseur 401 à deux sorties (notées chemin P et chemin N) de type classique en soi.

L'inverseur 401 reçoit sur une entrée 41 un signal d'entrée VIN et délivre sur des première « chemin P » et deuxième « chemin N » sorties des signaux d'entrée inversée VPOUT et VNOUT, respectivement. Cet inverseur 401 comprend un transistor TP5, dont la source SP5 est reliée à l'alimentation VCC et dont le drain DP5 est relié au chemin P, et un transistor TN5, dont la source SN5 est reliée au potentiel de référence VSS et dont le drain DN5 est relié au chemin N. Les transistors TP5 et TN5 reçoivent sur leur grille GP5 et GN5, le signal d'entrée VIN.

Ainsi, lorsque le signal d'entrée VIN est au niveau bas (c'est-à-dire égal au potentiel de référence VSS), soit 0V, alors les signaux de sortie VPOUT et VNOUT, délivrés respectivement sur le chemin P et le chemin N, sont tous deux fixés au niveau haut (c'est-à-dire à l'alimentation VCC), soit 3V.

A l'inverse, lorsque le signal d'entrée VIN est au niveau haut (c'est-à-dire égal à l'alimentation VCC), soit 3V, alors les signaux de sortie VPOUT et VNOUT, délivrés respectivement sur le chemin P et le chemin N, sont tous deux fixés au niveau bas (c'est-à-dire au potentiel de référence VSS), soit 0V.

Dans le mode de réalisation illustré, le circuit d'isolation 402 comprend une résistance d'isolation 404, dont une première extrémité 4041 est reliée au chemin P et une seconde extrémité 4042 est reliée au chemin N.

Comme on le verra dans la suite de la description, cette résistance d'isolation 404 permet d'isoler les pulses de bas vers haut sur le chemin P et les pulses de haut vers bas sur le chemin N, de façon à délivrer un signal de sortie non erroné (sans SET) sur au moins un des chemins.

De façon plus détaillée, lorsque le signal d'entrée VIN est au niveau bas, le transistor TN5 est placé dans un état bloqué (interrupteur ouvert) et le transistor TP5 dans un état passant (interrupteur fermé), dans lequel il fixe le signal de sortie VPOUT, délivré sur le chemin P, au niveau haut. Le signal de sortie VPOUT est acheminé vers le chemin N, via la résistance d'isolation 404. Le signal de sortie VNOUT est donc fixé au niveau haut.

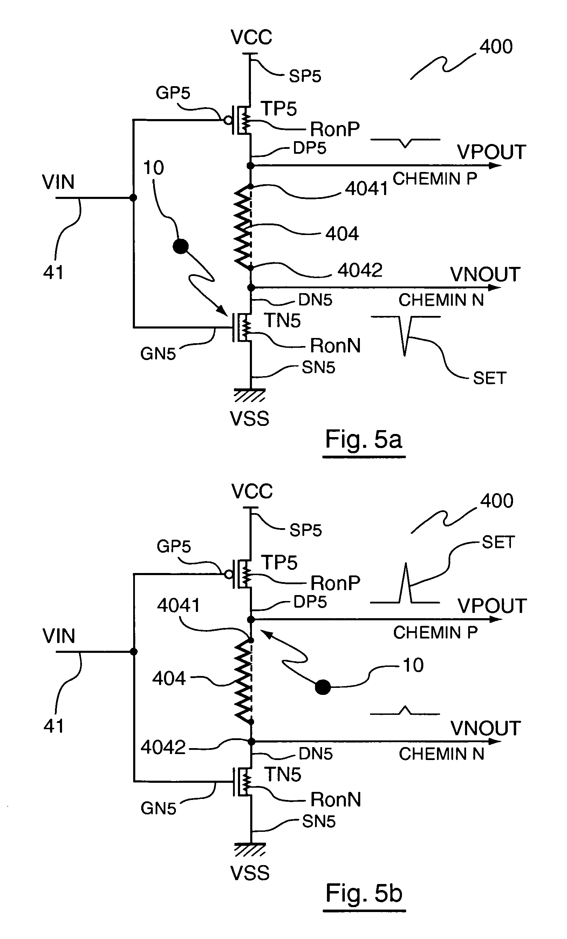

Comme illustré par la **figure 5a****,** lorsqu'une particule ionisante 10 percute le drain DN5 du transistor TN5, le phénomène de funneling court-circuite le drain DN5 polarisé au niveau haut avec le caisson du transistor TN5 polarisé au niveau bas et entraîne le passage transitoire du signal de sortie VNOUT du niveau haut (de 3V) vers le niveau bas (0V) (c'est-à-dire un pulse de haut vers bas). Le chemin N, relié au drain DN5 du transistor TN5, est donc transitoirement connecté au potentiel de référence VSS, soit 0V, induisant ainsi une décharge de la capacité du drain DN5 du transistor TN5.

Selon un aspect particulier de l'invention, la résistance d'isolation 404 et la résistance RonP du transistor TP5 forment un pont diviseur en tension, dont l'entrée correspond à la seconde extrémité 4042 de la résistance d'isolation 404 et la sortie à la première extrémité 4041 de cette résistance d'isolation.

Dans le présent mode de réalisation, la valeur de la résistance RonP du transistor TP5 est supérieure à la valeur de la résistance d'isolation 404.

Ainsi, lorsqu'un pulse de haut vers bas apparaît à la seconde extrémité 4042 de la résistance d'isolation 404, la perturbation en tension générée aux bornes de la résistance RonP a une amplitude beaucoup plus faible que l'amplitude du pulse du chemin N et est inférieure à la tension de seuil du transistor TP5. En d'autres termes, la résistance d'isolation 404 permet de maintenir les pulses de haut vers bas sur le chemin N (pas de propagation sur le chemin P).

A l'inverse, et comme illustré par la **figure 5b**, lorsque le signal d'entrée VIN est au niveau haut, le transistor TP5 est placé dans un état bloqué (interrupteur ouvert) et le transistor TN5 dans un état passant (interrupteur fermé), dans lequel il fixe le signal de sortie VNOUT, délivré sur le chemin N, au niveau bas. Le signal de sortie VNOUT est acheminé vers le chemin P, via la résistance d'isolation 404. Le signal de sortie VPOUT est donc fixé au niveau bas.

Lorsqu'une particule ionisante 10 percute le drain DP5 du transistor TP5, le phénomène de funneling court-circuite le drain DP5 polarisé au niveau bas avec le caisson du transistor TP5 polarisé au niveau haut et entraîne le passage transitoire du signal de sortie VPOUT du niveau bas (de 0V) vers le niveau haut (de 3V) (c'est-à-dire un pulse de bas vers haut). Le chemin P, relié au drain DP5 du transistor TP5, est donc transitoirement connecté à l'alimentation VCC, soit 3V, induisant ainsi une charge de la capacité du drain DP5 du transistor TP5.

La résistance d'isolation 404 et la résistance RonN du transistor TN5 forment un pont diviseur en tension, dont l'entrée correspond à la première extrémité 4041 de la résistance d'isolation 404 et la sortie à la seconde extrémité 4042 de cette résistance d'isolation.

Dans ce mode de réalisation, la valeur de la résistance RonN du transistor TN5 est supérieure à la valeur de la résistance d'isolation 404.

Ainsi, lorsqu'un pulse dé bas vers haut apparaît à la première extrémité 4041 de la résistance d'isolation 404, la perturbation en tension générée aux bornes de la résistance RonN a une amplitude beaucoup plus faible que l'amplitude du pulse du chemin N et est inférieure à la tension de seuil du transistor TN5. En d'autres termes, la résistance d'isolation 404 permet de maintenir les pulses de bas vers haut sur le chemin P (pas de propagation sur le chemin N).

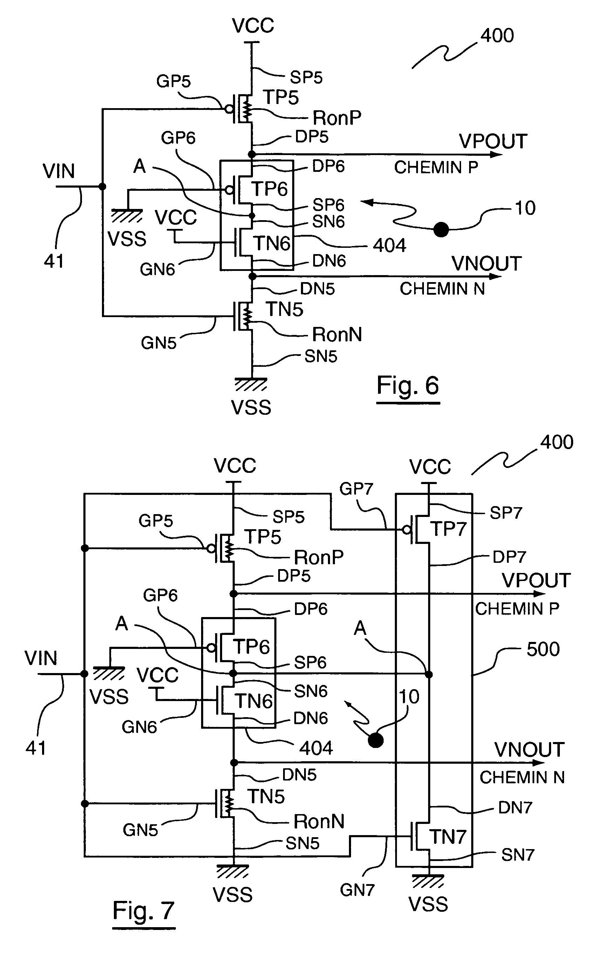

On décrit maintenant en référence à la figure 6, l'architecture de la résistance d'isolation 404 (figure 4) selon un premier mode de réalisation préférentiel de l'invention.

Dans ce mode de réalisation particulier, l'invention propose de former la résistance d'isolation 404 par la mise en série de deux transistors d'isolation : un transistor PMOS TP6 et un transistor NMOS TN6.

De façon à obtenir un pont diviseur tel que décrit ci-dessus en relation avec les figures 5a et 5b, la valeur de la résistance d'isolation 404 doit être supérieure à la valeur des résistances RonP et RonN des transistors TP5 et TN5, formant l'inverseur 401. Pour ce faire, les dimensions physiques des transistors d'isolation TP6 et TN6 doivent être plus petites que celles des transistors TP5 et TN5 de l'inverseur 401.

Dans le mode de réalisation illustré, la largeur du canal des transistors d'isolation TP6 et TN6 est deux fois plus petite que celle des transistors TP5 et TN5 de l'inverseur 401.

De façon plus détaillée, la résistance d'isolation 404 comprend elle-même un transistor d'isolation TP6, dont le drain DP6 est relié au chemin P (c'est-à-dire au drain DP5 du transistor TP5) et dont la source SP6 est reliée à un point milieu A, et un transistor d'isolation TN6, dont le drain DN6 est relié au chemin N (c'est-à-dire au drain DN5 du transistor TN5) et dont la source SN6 est reliée au point milieu A.

Les transistors d'isolation TP6 et TN6 sont polarisés de façon à être en permanence dans un état passant. Pour ce faire, la grille GP6 du transistor d'isolation TP6 est reliée à l'alimentation VCC du circuit et la grille GN6 du transistor d'isolation TN6 est reliée au potentiel de référence VSS.

On décrit ci-après en référence à la figure 7, l'architecture de la résistance d'isolation 404 (figure 4) selon un second mode de réalisation préférentiel de l'invention.

L'insertion de la résistance d'isolation 404 (c'est-à-dire la création du chemin résistif) peut introduire un décalage temporel (ou « skew » en anglais) non négligeable entre les signaux de sortie VPOUT et VNOUT délivrés sur les chemins P et N, respectivement.

A titre d'exemple, lorsque le signal d'entrée VIN est au niveau bas, le transistor TN5 est dans un état bloqué et le transistor TP5 dans un état passant, dans lequel il fixe le signal de sortie VPOUT, délivré sur le chemin P, au niveau haut. Le signal de sortie VPOUT est ensuite acheminé vers le chemin N, via la résistance d'isolation 404. Cette résistance d'isolation 404, du fait de sa forte valeur résistive, peut retarder de quelques centaines de picosecondes le passage du signal de sortie VNOUT du niveau bas vers le niveau haut.

Dans cette variante de mise en oeuvre, les transistors d'isolation TP6 et TN6, tels que décrits ci-dessus en relation avec la figure 6, coopèrent avec des moyens d'accélération 500 (aussi appelés par la suite moyens de synchronisation), permettant de réduire les retards entre les chemins P et N.

Comme on le verra par la suite, les moyens d'accélération 500 permettent de court-circuiter les transistors d'isolation TP6 et TN6, en fonction du niveau du signal d'entrée VIN.

Ces moyens d'accélération 500 comprennent un transistor de dérivation TP7 (aussi appelé transistor de « shunt » dans la suite de la description), dont la source SP7 est reliée à l'alimentation VCC et dont le drain DP7 est relié au point milieu A (c'est-à-dire aux sources SP6 et SN6 des transistors TP6 et TN6), et un transistor de dérivation TN7, dont la source SN7 est reliée au potentiel de référence VSS et dont le drain DN7 est relié au point milieu A. Les transistors de dérivation TP7 et TN7 reçoivent sur leur grille GP7 et GN7, le signal d'entrée VIN.

Ainsi, lorsque le signal d'entrée VIN est au niveau bas, le transistor TN5 est dans un état bloqué et le transistor TP5 dans un état passant, dans lequel il fixe le signal de sortie VPOUT, délivré sur le chemin P, au niveau haut. Le transistor TN7 est dans un état bloqué et le transistor TP7 dans un état passant, dans lequel il applique directement l'alimentation VCC au point milieu A. Le transistor TN6 qui est en permanence dans un état passant transfert le niveau du point milieu A sur le chemin N. Le signal de sortie VNOUT est donc fixé au même niveau que le signal de sortie VPOUT, c'est-à-dire au niveau haut.

Il est important de noter que la résistance du transistor de shunt TP7 est beaucoup plus faible que celle du transistor d'isolation TP6. Ainsi, le transistor de shunt TP7 achemine plus rapidement l'alimentation VCC au point milieu A. Le transistor d'isolation TP6 est donc « court-circuité » par le transistor de shunt TP7.

A l'inverse, lorsque le signal d'entrée VIN est au niveau haut, le transistor TP5 est dans un état bloqué et le transistor TN5 dans un état passant, dans lequel il fixe le signal de sortie VNOUT, délivré sur le chemin N, au niveau bas. Le transistor TP7 est dans un état bloqué et le transistor TN7 dans un état passant, dans lequel il applique directement le potentiel de référence VSS au point milieu A. Le transistor TP6 qui est en permanence dans un état passant transfert le niveau du point milieu A sur le chemin P. Le signal de sortie VPOUT est donc fixé au même niveau que le signal de sortie VNOUT, c'est-à-dire au niveau bas.

On note également que la résistance du transistor de shunt TN7 est beaucoup plus faible que celle du transistor d'isolation TN6. Ainsi, le transistor de shunt TN7 achemine plus rapidement le potentiel de référence VSS au point milieu A. Le transistor d'isolation TP6 est donc « court-circuité » par le transistor de shunt TP7.

Dans un mode de réalisation préférentiel, les transistors de shunt TP7 et TN7 sont identiques aux transistors TP5 et TN5 de l'inverseur, respectivement.

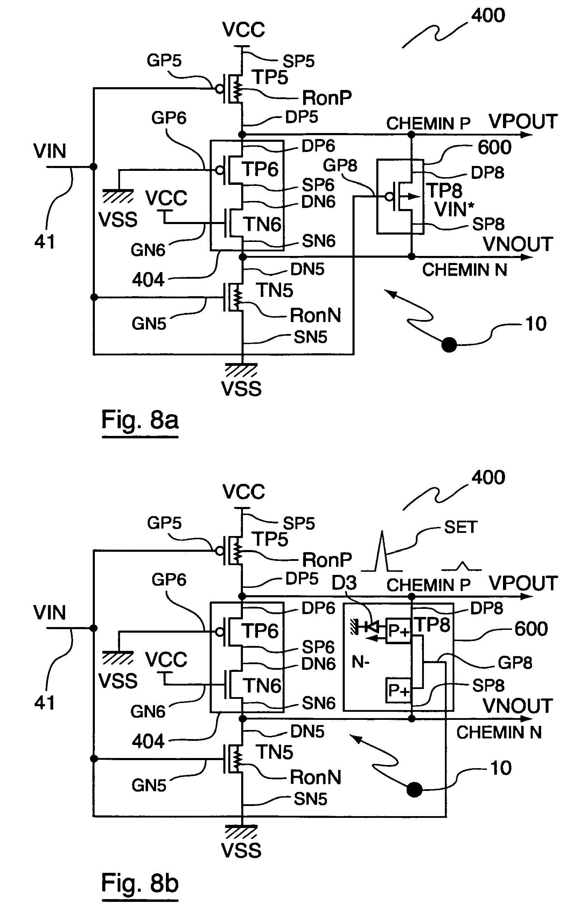

On va décrire maintenant en relation avec la **figure 8a****,** l'architecture de la résistance d'isolation 404 (figure 4) selon un troisième mode de réalisation préférentiel de l'invention.

Comme déjà indiqué, la cellule logique CMOS 400 comprend une résistance d'isolation 404 permettant d'isoler les pulses de bas vers haut sur le chemin P et les pulses de haut vers bas sur le chemin N. Cependant, cette résistance d'isolation 404 ne permet pas de réduire l'amplitude et la largeur de ces pulses isolés, qui sont source d'informations erronées.

Dans cette autre variante de réalisation, les transistors d'isolation TP6 et TN6, tels que décrits ci-dessus en relation avec la figure 6, coopèrent avec des moyens d'évacuation 600 (aussi appelés par la suite moyens de filtrage), permettant de réduire l'amplitude et la largeur des pulses (ou SET) isolés sur les chemins P et N. Comme on le verra ci-après, les moyens d'évacuation 600 sont montés en parallèle à la résistance d'isolation 404.

Ces moyens d'évacuation 600 comprennent un transistor à caisson commandé TP8, dont la source SP8 est reliée au chemin N et dont le drain DP8 est relié au chemin P. Le transistor à caisson commandé TP8 reçoit sur sa grille GP8, le signal d'entrée VIN.

Il est important de noter que la grille GP8 du transistor TP8 est polarisée par le signal d'entrée VIN, tandis que le caisson de ce transistor TP8 est polarisé par l'inverse du signal d'entrée VIN*.

Ainsi, lorsque le signal d'entrée VIN est au niveau haut, le transistor TP5 est dans un état bloqué et le transistor TN5 dans un état passant, dans lequel il fixe le signal de sortie VNOUT, délivré sur le chemin N, au niveau bas. Le signal de sortie VNOUT est ensuite acheminé vers le chemin P, via la résistance d'isolation 404. Le signal de sortie VPOUT est donc fixé au niveau bas.

Le transistor à caisson commandé TP8 est dans un état bloqué, et son caisson est polarisé au niveau bas, du fait que les signaux de sortie VNOUT (appliqué sur la source SP8) et VPOUT (appliqué sur le drain DP8) sont tous deux au niveau bas. Ainsi, ce transistor à caisson commandé TP8, bien que bloqué, ne peut pas induire un phénomène de funneling, lors d'un impact d'une particule ionisante sur son drain DP8. Le transistor TP8 ne peut donc pas perturber les signaux de sortie VNOUT et VPOUT.

Comme illustré par la **figure 8b**, lorsqu'une particule ionisante 10 percute le drain DP5 du transistor TP5 ou le drain DP6 du transistor d'isolation TP6, un pulse de bas vers haut apparaît sur le chemin P.

Selon l'invention, le transistor à caisson commandé TP8 joue le rôle d'une diode d'évacuation, permettant d'évacuer les charges présentes sur le chemin P dans le substrat N du transistor TP8.

En d'autres termes, le transistor à caisson commandé TP8 permet de réduire l'amplitude et la largeur des pulses de bas vers haut du chemin P, par l'évacuation des charges via la diode PN verticale D3 du transistor TP8.

En revanche, lorsque le signal d'entrée VIN est au niveau bas, le transistor TN5 est dans un état bloqué et le transistor TP5 dans un état passant, dans lequel il fixe le signal de sortie VPOUT, délivré sur le chemin P, au niveau haut.

Le transistor à caisson commandé TP8 est dans un état passant (donc pas de phénomène de funneling possible du fait que son drain est polarisé au même niveau que son caisson), dans lequel il court-circuite les transistors d'isolation TP6 et TN6, de façon à acheminer plus rapidement et sans dégradation (c'est-à-dire sans décalage de niveau) le niveau haut du chemin P sur le chemin N. Le transistor à caisson commandé TP8 permet donc de restituer le niveau du chemin P sur le chemin N.

On note que le caisson du transistor TP8 est polarisé au niveau haut, du fait que les signaux de sortie VNOUT (appliqué sur la source SP8) et VPOUT (appliqué sur le drain DP8) sont tous deux au niveau haut. Le transistor TP8 ne peut donc pas induire de phénomène de funneling et perturber les signaux de sortie VNOUT et VPOUT.

Dans une variante de réalisation, on peut envisager de remplacer le transistor à caisson commandé TP8 de type PMOS par un transistor à caisson commandé de type NMOS, en utilisant des tranches de silicium (ou « wafer » en anglais) de type N.

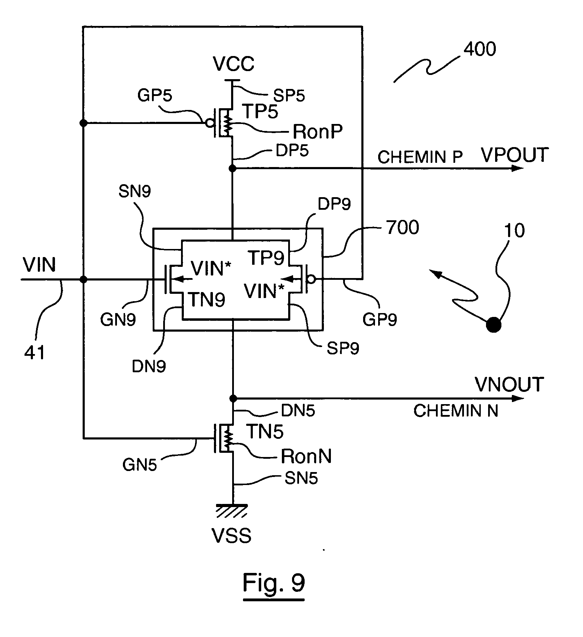

On présente maintenant, en relation avec la **figure 9**, l'architecture de la résistance d'isolation 404 (figure 4) selon un quatrième mode de réalisation préférentiel de l'invention.

Dans ce mode de réalisation préférentiel, on remplace les transistors d'isolation TP6 et TN6 (figure 6) par un mécanisme à double caisson commandé 700, réalisé en technologie CMOS silicium sur isolant (ou «SOI» pour « Silicium On Insulator » en anglais). Cette technologie SOI permet avantageusement d'utiliser en parallèle des transistors N et P à caisson commandé.

Comme on le verra dans la suite de la description, ce mécanisme à double caisson commandé 700 permet de restituer les niveaux de tension sur les deux chemins d'une part et d'évacuer les charges intempestives générées sur les deux chemins d'autre part, de façon à délivrer des signaux de sortie non erronés (sans SET) sur les deux chemins P et N de la cellule logique 400.

De façon plus détaillée, le mécanisme à double caisson commandé 700 comprend un transistor TP9 à caisson commandé, dont la source SP9 est reliée au chemin N et dont le drain DP9 est relié au chemin P, et un transistor TN9 à caisson commandé, dont la source SN9 est reliée au chemin P et dont le drain DN9 est relié au chemin N. Les transistors à caisson commandé TP9 et TN9 reçoivent sur leur grille GP9 et GN9, le signal d'entrée VIN.

Il est important de noter que les grilles GP9 et GN9 des transistors TP9 et TN9 sont polarisées par le signal d'entrée VIN, tandis que leurs caissons sont polarisés par l'inverse du signal d'entrée VIN*.

De façon à obtenir un pont diviseur tel que décrit ci-dessus en relation avec les figures 5a et 5b, la valeur des résistances des transistors à caisson commandé TP9 et TN9 doit être supérieure à la valeur des résistances RonP et RonN des transistors TP5 et TN5, formant l'inverseur 401. Pour ce faire, les dimensions physiques des transistors à caisson commandé TP9 et TN9 doivent être plus petites que celles des transistors TP5 et TN5 de l'inverseur 401.

Dans un mode de réalisation préférentiel, la largeur du canal des transistors à caisson commandé TP9 et TN9 est deux fois plus petite que celle des transistors TP5 et TN5 de l'inverseur 401.

Il est important de noter que les grilles GP9 et GN9 des transistors à caisson commandé TP9 et TN9 sont polarisées par le signal d'entrée VIN, tandis que leurs caissons sont polarisés par l'inverse du signal d'entrée VIN.

Ainsi, lorsque le signal d'entrée VIN est au niveau haut, le transistor TP5 est dans un état bloqué et le transistor TN5 dans un état passant, dans lequel il fixe le signal de sortie VNOUT, délivré sur le chemin N, au niveau bas. Le transistor à caisson commandé TN9 est dans un état passant, dans lequel il applique directement le niveau bas du chemin N sur le chemin P. Le signal de sortie VPOUT est donc fixé au même niveau que le signal de sortie VNOUT, c'est-à-dire au niveau bas.

Le transistor à caisson commandé TP9 est dans un état bloqué, et son caisson est polarisé au niveau bas, du fait que les signaux de sortie VNOUT (appliqué sur la source SP9) et VPOUT (appliqué sur le drain DP9) sont tous deux au niveau bas. Ainsi, ce transistor à caisson commandé TP9, bien que bloqué, ne peut pas provoquer de phénomène de funneling, lors d'un impact d'une particule ionisante sur son drain DP9.

En revanche, lorsqu'une particule ionisante 10 percute le drain DP5 du transistor TP5 (qui est dans un état bloqué), un pulse de bas vers haut apparaît sur le chemin P. Dans ce cas, le transistor à caisson commandé TP9 joue le rôle d'une diode d'évacuation, permettant d'évacuer les charges présentes sur le chemin P dans le substrat N du transistor TP9. En d'autres termes, le transistor à caisson commandé TP9 permet de réduire l'amplitude et la largeur des pulses de bas vers haut du chemin P, par l'évacuation des charges via sa diode drain-caisson (non représentée).

A l'inverse, lorsque le signal d'entrée VIN est au niveau bas, le transistor TN5 est dans un état bloqué et le transistor TP5 dans un état passant, dans lequel il fixe le signal de sortie VPOUT, délivré sur le chemin P, au niveau haut. Le transistor à caisson commandé TP9 est dans un état passant, dans lequel il applique directement le niveau haut du chemin P sur le chemin N. Le signal de sortie VNOUT est donc fixé au même niveau que le signal de sortie VPOUT, c'est-à-dire au niveau haut.

Le transistor à caisson commandé TN9 est dans un état bloqué, et son caisson est polarisé au niveau haut, du fait que les signaux de sortie VNOUT (appliqué sur la source SN9) et VPOUT (appliqué sur le drain DN9) sont tous deux au niveau haut. Ainsi, ce transistor à caisson commandé TN9, bien que bloqué, ne peut pas provoquer de phénomène de funneling, lors d'un impact d'une particule ionisante sur son drain DN9.

En revanche, lorsqu'une particule ionisante 10 percute le drain DN5 du transistor TN5 (qui est dans un état bloqué), un pulse de haut vers bas apparaît sur le chemin N. Dans ce cas, le transistor à caisson commandé TN9 joue le rôle d'une diode d'évacuation, permettant d'évacuer les charges présentes sur le chemin N dans le substrat P du transistor TN9. En d'autres termes, le transistor à caisson commandé TN9 permet de réduire l'amplitude et la largeur des pulses de haut vers bas du chemin N, par l'évacuation des charges via sa diode drain-caisson (non représentée).

En résumé, la cellule logique CMOS, telle que proposée par l'invention, présente de nombreux avantages, dont une liste non exhaustive est donnée ci-dessous :
- amélioration de la consommation électrique statique ; en effet, l'invention permet de créer un chemin résistif entre les sorties de la cellule logique CMOS et de supprimer tout chemin direct entre l'alimentation et le potentiel de référence di circuit ;
- amélioration de la stabilité ; en effet, l'invention permet de réduire l'amplitude et la largeur des impulsions transitoires (SET) générées sur les sorties de la cellule logique CMOS, et ce quel que soit le niveau du signal d'entrée.

Bien entendu, l'invention n'est pas limitée aux exemples de réalisation mentionnés ci-dessus. On a décrit un inverseur mais bien sûr la même approche s'applique à tout autre porte logique à sorties redondantes.

En particulier, l'Homme du Métier pourra, en fonction de l'isolation souhaitée, modifier le rapport de résistivité entre les transistors d'isolation et les transistors de l'inverseur. Notamment, il est possible d'envisager la mise en série de plusieurs transistors PMOS et NMOS, de façon à augmenter la valeur de la résistance d'isolation.

D'une façon générale, dans d'autres exemples de réalisation, les valeurs de VCC, VSS et du rapport des largeurs du canal des transistors peuvent être différentes de celles données dans le cas du mode de réalisation préférentiel exposé ci-dessus.

Bien que l'invention ait été décrite ci-dessus en relation avec un nombre limité de modes de réalisation, l'homme du métier, à la lecture de la présente description, comprendra que d'autres modes de réalisation peuvent être imaginés sans sortir du cadre de la présente invention.

## Revendications

1. Cellule logique (400) pour circuit intégré, comprenant deux sorties redondantes, une première sortie (chemin P) équipée d'un transistor de sortie de type P (TP5) et une seconde sortie (chemin N) équipée d'un transistor de sortie de type N (TN5),
et comprenant également un circuit d'isolation (402) reliant lesdites première et seconde sorties pour former une résistance d'isolation (404),
ladite cellule logique (400) étant **caractérisée en ce que** ledit circuit d'isolation (402) comprend un premier transistor d'isolation de type P (TP6) monté en série avec un second transistor d'isolation de type N (TN6), les drains (DP6, DN6) des premier et second transistors d'isolation étant connectés respectivement aux drains (DP5, DN5) des premier et second transistors de sortie, la grille (GP6) du premier transistor d'isolation étant reliée à une première tension de référence (VSS) et la grille (GN6) du second transistor d'isolation étant reliée à une seconde tension de référence (VCC).

2. Cellule logique (400) selon la revendication 1, **caractérisée en ce que** ladite résistance d'isolation (404) est inférieure à la résistance du premier (RonP) et/ou du second (RonN) transistors de sortie.

3. Cellule logique (400) selon la revendication 1, **caractérisée en ce que** la première tension de référence (VSS) est une masse et **en ce que** la seconde tension de référence (VCC) est une tension d'alimentation.

4. Cellule logique (400) selon l'une quelconque des revendications 1 à 3, **caractérisée en ce que** la largeur du canal de chacun desdits transistors d'isolation (TP6, TN6) est inférieure à la moitié de la largeur du canal de chacun desdits transistors de sortie (TP5, TN5).

5. Cellule logique (400) selon l'une quelconque des revendications 1 à 4, **caractérisée en ce que** ledit circuit d'isolation (402) comprend des moyens de synchronisation (500) entre les signaux présents (VPOUT, VNOUT) sur lesdites premières et secondes sorties.

6. Cellule logique (400) selon la revendication 5, **caractérisée en ce que** les moyens de synchronisation (500) comprennent un premier transistor de dérivation de type P (TP7), dont la grille (GP7) est reliée à la grille (GP5) du transistor de sortie de type P, la source (SP7) est reliée à la seconde tension de référence (VCC) et le drain (DP7) est relié aux sources (SP6, SN6) des transistors d'isolation, et un second transistor de dérivation de type N (TN7) dont la grille (GN7) est reliée à la grille (GN5) du transistor de sortie de type N, la source (SN7) est reliée à la première tension de référence (VSS) et le drain (DN7) est relié aux sources (SP6, SN6) des transistors d'isolation.

7. Cellule logique (400) selon l'une quelconque des revendications 1 à 6, **caractérisée en ce qu'**elle comprend en outre des moyens de filtrage (600) d'au moins une perturbation des signaux (VPOUT, VNOUT) présents sur la première (chemin P) et/ou la seconde (chemin N) sortie due à au moins une particule (10) chargée sur au moins un des transistors.

8. Cellule logique (400) selon la revendication 7, **caractérisée en ce que** lesdits moyens de filtrage (600) comprennent au moins un transistor à caisson commandé (TP8).

9. Cellule logique (400) selon la revendication 8, **caractérisée en ce que** lesdits moyens de filtrage (600) comprennent un premier transistor de filtrage de type P à caisson commandé dont la source est reliée à la seconde sortie, le drain à la première sortie et la grille à l'entrée (41) de ladite cellule et/ou un second transistor de filtrage de type N à caisson commandé dont le drain est relié à la seconde sortie, la source à la première sortie et la grille à l'entrée (41) de ladite cellule.

10. Cellule logique selon l'une quelconque des revendications 1 à 9, **caractérisée en ce que** ledit circuit d'isolation (402) comprend un troisième transistor d'isolation de type P (TP9) à caisson commandé dont la source (SP9) est reliée à la seconde sortie (chemin N), le drain (DP9) à la première sortie (chemin P) et la grille (GP9) à l'entrée (41) de ladite cellule et un quatrième transistor d'isolation de type N (TN9) à caisson commandé dont le drain (DN9) est relié à la seconde sortie (chemin N), la source (SN9) à la première sortie (chemin P) et la grille (GN9) à l'entrée (41) de ladite cellule.

11. Cellule logique (400) selon l'une quelconque des revendications 1 à 10, **caractérisée en ce que** la source (SP5) du transistor de sortie de type P (TP5) est reliée à la seconde tension de référence (VCC) et la source (SN5) du transistor de sortie de type N (TN5) est reliée à la première tension de référence (VSS) et **en ce que** l'entrée (41) de ladite cellule est reliée aux grilles (GP5, GN5) des transistors de sortie.

12. Circuit intégré comprenant au moins une cellule logique selon l'une quelconque des revendications 1 à 11.

## Claims

1. Logic cell (400) for an integrated circuit, including two redundant outputs, a first output (path P) equipped with an output transistor of type P (TP5) and a second output (path N) equipped with an output transistor of type N (TN5), and including an isolation circuit (402) connecting said first and second outputs to form an isolation resistance (404), said logic cell (400) being **characterised in that** said isolation circuit (402) includes a first isolation transistor of type P (TP6) mounted in series with a second isolation transistor of type N (TN6), with the drains (DP6, DN6) of the first and second isolation transistors being connected respectively to the drains (DP5, DN5) of the first and second output transistors, the gate (GP6) of the first isolation transistor being connected to a first reference voltage (VSS) and the gate (GN6) of the second isolation transistor being connected to a second reference voltage (VCC).

2. Logic cell (400) according to claim 1, **characterised in that** said isolation resistance (404) is smaller than the resistance of the first (RonP) and/or second (RonN) output transistors.

3. Logic cell (400) according to claim 1, wherein the first reference voltage (VSS) is a ground and in that the second reference voltage (VCC) is a power supply voltage.

4. Logic cell (400) according to any one of claims 1 to 3, wherein the width of the channel of each of said isolation transistors (TP6, TN6) is smaller than half the width of the channel of each of said output transistors (TP5, TN5).

5. Logic cell (400) according to any one of claims 1 to 4, wherein said isolation circuit (402) includes means for synchronisation (500) between the signals present (VPOUT, VNOUT) on said first and second outputs.

6. Logic cell (400) according to claim 5, wherein the synchronisation means (500) include a first bypass transistor of type P (TP7), of which the gate (GP7) is connected to the gate (GP5) of the output transistor of type P, the source (SP7) is connected to the second reference voltage (VCC) and the drain (DP7) is connected to the sources (SP6, SN6) of the isolation transistors, and a second bypass transistor of type N (TN7) of which the gate (GN7) is connected to the gate (GN5) of the output transistor of type N, the source (SN7) is connected to the first reference voltage (VSS) and the drain (DN7) is connected to the sources (SP6, SN6) of the isolation transistors.

7. Logic cell (400) according to any one of claims 1 to 6, wherein the logic cell also includes means for filtering (600) at least one disturbance of the signals (VPOUT, VNOUT) present on the first (path P) and/or the second (path N) output due to at least one charged particle (10) on at least one of the transistors.

8. Logic cell (400) according to claim 7, wherein said filtering means (600) include at least one commanded-well transistor (TP8).

9. Logic cell (400) according to claim 8, wherein said filtering means (600) include a first commanded-well filtering transistor of type P of which the source is connected to the second output, the drain is connected to the first output and the gate is connected to the input (41) of said cell and/or a second commanded-well filtering transistor of type N of which the drain is connected to the second output, the source is connected to the first output and the gate is connected to the input (41) of said cell.

10. Logic cell according to any one of claims 1 to 9, wherein said isolation circuit (402) includes a third commanded-well isolation transistor of type P (TP9) of which the source (SP9) is connected to the second output (path N), the drain (DP9) is connected to the first output (path P) and the gate (GP9) is connected to the input (41) of said cell and a fourth commanded-well isolation transistor of type N (TN9) of which the drain (DN9) is connected to the second output (path N), the source (SN9) is connected to the first output (path P) and the gate (GN9) is connected to the input (41) of said cell.

11. Logic cell (400) according to any one of claims 1 to 10, wherein the source (SP5) of the output transistor of type P (TP5) is connected to the second reference voltage (VCC) and the source (SN5) of the output transistor of type N (TN5) is connected to the first reference voltage (VSS) and in that the input (41) of said cell is connected to the gates (GP5, GN5) of the output transistors.

12. Integrated circuit including at least one logic cell according to any one of claims 1 to 11.

## Patentansprüche

1. Logikzelle (400) für eine integrierte Schaltung, die zwei redundante Ausgänge aufweist, einen ersten Ausgang (Pfad P), der mit einem Ausgangstransistor des Typs P (TP5) ausgestattet ist, und einen zweiten Ausgang (Pfad N), der mit einem Ausgangstransistor des Typs N (TN5) ausgestattet ist,
und auch eine Trennschaltung (402) aufweist, die den ersten und den zweiten Ausgang verbindet, um einen Isolierwiderstand (404) zu bilden,
wobei die Logikzelle (400) **dadurch gekennzeichnet ist, dass** die Trennschaltung (402) einen ersten Trenntransistor des Typs P (TP6) aufweist, der mit einem zweiten Trenntransistor des Typs N (TN6) in Reihe geschaltet ist, wobei die Drains (DP6, DN6) des ersten und des zweiten Trenntransistors jeweils mit den Drains (DP5, DN5) des ersten und des zweiten Ausgangstransistors verbunden sind, wobei das Gate (GP6) des ersten Trenntransistors mit einer ersten Referenzspannung (VSS) verbunden ist, und das Gate (GN6) des zweiten Trenntransistors mit einer zweiten Referenzspannung (VCC) verbunden ist.

2. Logikzelle (400) nach Anspruch 1, **dadurch gekennzeichnet, dass** der Isolierwiderstand (404) kleiner ist als der Widerstand des ersten (RonP) und/oder des zweiten (RonN) Ausgangstransistors.

3. Logikzelle (400) nach Anspruch 1, **dadurch gekennzeichnet, dass** die erste Referenzspannung (VSS) eine Masse ist, und dass die zweite Referenzspannung (VCC) eine Versorgungsspannung ist.

4. Logikzelle (400) nach einem der Ansprüche 1 bis 3, **dadurch gekennzeichnet, dass** die Breite des Kanals jedes der Trenntransistoren (TP6, TN6) kleiner ist als die Hälfte der Breite des Kanals jedes der Ausgangstransistoren (TP5, TN5).

5. Logikzelle (400) nach einem der Ansprüche 1 bis 4, **dadurch gekennzeichnet, dass** die Trennschaltung (402) Mittel (500) zum Synchronisieren zwischen den gegenwärtigen Signalen (VPOUT, VNOUT) auf dem ersten und auf dem zweiten Ausgang aufweist.

6. Logikzelle (400) nach Anspruch 5, **dadurch gekennzeichnet, dass** die Synchronisationsmittel (500) einen ersten Abzweigtransistor des Typs P (TP7) aufweisen, dessen Gate (GP7) mit dem Gate (GP5) des Ausgangstransistors des Typs P verbunden ist, die Source (SP7) mit der zweiten Referenzspannung (VCC) und der Drain (DP7) mit den Sources (SP6, SN6) der Trenntransistoren verbunden ist, und einen zweiten Abzweigtransistor des Typs N (TN7), dessen Gate (GN7) mit dem Gate (GN5) des Ausgangstransistors des Typs N verbunden ist, die Source (SN7) mit der ersten Referenzspannung (VSS) verbunden ist, und der Drain (DN7) mit den Sources (SP6, SN6) der Trenntransistoren verbunden ist.

7. Logikzelle (400) nach einem der Ansprüche 1 bis 6, **dadurch gekennzeichnet, dass** sie ferner Mittel (600) zum Filtern mindestens einer Störung der Signale (VPOUT, VNOUT), die auf dem ersten (Pfad P) und/oder dem zweiten (Pfad N) gegenwärtig sind, die auf mindestens ein geladenes Teilchen (10) auf mindestens einem der Transistoren zurückzuführen ist, aufweist.

8. Logikzelle (400) nach Anspruch 7, **dadurch gekennzeichnet, dass** die Filtermittel (600) mindestens einen Transistor mit gesteuerter Wanne (TP8) aufweisen.

9. Logikzelle (400) gemäß Anspruch 8, **dadurch gekennzeichnet, dass** die Filtermittel (600) einen ersten Filtertransistor des Typs P mit gesteuerter Wanne aufweisen, deren Source mit dem zweiten Ausgang, der Drain mit dem ersten Ausgang und das Gate mit dem Eingang (41) der Zelle verbunden ist, und/oder einen zweiten Filtertransistor des Typs N mit gesteuerter Wanne, dessen Drain mit dem zweiten Ausgang, die Source mit dem ersten Ausgang und das Gate mit dem Eingang (41) der Zelle verbunden ist.

10. Logikzelle (400) nach einem der Ansprüche 1 bis 9, **dadurch gekennzeichnet, dass** die Trennschaltung (402) einen dritten Trenntransistor des Typs P (TP9) mit gesteuerter Wanne aufweist, deren Source (SP9) mit dem zweiten Ausgang (Pfad N), der Drain (DP9) mit dem ersten Ausgang (Pfad P) und das Gate (GP9) mit dem Eingang (41) der Zelle verbunden ist, und einen vierten Trenntransistor des Typs N (TN9) mit gesteuerter Wanne, dessen Drain (DN9) mit dem zweiten Ausgang (Pfad N), die Source (SN9) mit dem ersten Ausgang (Pfad P) und das Gate (GN9) mit dem Eingang (41) der Zelle verbunden ist.

11. Logikzelle (400) nach einem der Ansprüche 1 bis 10, **dadurch gekennzeichnet, dass** die Source (SP5) des Ausgangstransistors des Typs P (TP5) mit der zweiten Referenzspannung (VCC) verbunden ist, und die Source (SN5) des Ausgangstransistors des Typs N (TN5) mit der ersten Referenzspannung (VSS) verbunden ist, und dass der Eingang (41) der Zelle mit den Gates (GP5, GN5) der Ausgangstransistoren verbunden ist.

12. Integrierte Schaltung, die mindestens eine Logikzelle nach einem der Ansprüche 1 bis 11 aufweist.
